# EUROPEAN PATENT APPLICATION

(11) **EP 4 335 946 A1**
(43) Date of publication of application: **13.03.2024**
(21) Application number: 22194348.3
(22) Date of filing: 07.09.2022
(51) Int. Cl.: C23F 13/22, G01N 17/02, B63B 59/00, E02B 17/00

(54) **MARINE CATHODIC PROTECTION MONITORING SYSTEM AND AN EXTERNAL UNIT**

(71) Applicant: Volvo Penta Corporation, 405 08 Göteborg (SE)
(72) Inventor: RÄFTEGÅRD, Viktor, 448 31 Floda (SE); KÄLLVIK, Johan, 441 74 Sollebrunn (SE)
(74) Representative: Valea AB

(57) **Abstract**

The invention relates to a marine cathodic protection monitoring system comprising an on-board internal monitoring unit (113; 213) arranged to receive measurement data from a submerged external unit (108, 109; 208, 209; 300; 500; 600; 700; 800; 900). The external unit is mounted in direct contact with a cathodically protected structure (310) and which external unit is powered by a dedicated source of power (308; 508; 608; 612; 613). The external unit comprises reference electrodes (301; 501; 601; 701; 801; 901) arranged in electrical connection with the cathodically protected structure (310), a voltmeter (302; 502; 602) arranged to monitor the potential difference and means for at least transmitting data (303; 503; 603) using a wireless protocol. The external unit (108, 109; 208, 209; 300; 500; 600; 700; 800; 900) is arranged to transmit measurement data indicating the current potential difference of the structure.

## Description

### TECHNICAL FIELD

The present disclosure relates to a marine cathodic protection monitoring system comprising an on-board internal monitoring unit arranged to receive measurement data from a submerged external unit in order to determine whether the cathodic protection potential is within a predetermined range.

### BACKGROUND

Seawater is a relatively corrosive environment and various immersed metallic parts used in marine applications such as vessels or floating structures require corrosion protection to avoid or minimize corrosion. A corrosion protection (CP) system is arranged to use an anode to shift the galvanic potential of the protected part or structure into a desired interval, which depends on the metallic material to be protected. There are many factors that can affect the function of a CP system, such as anode consumption, anode passivation, increased CP current demand, stray currents, etc. Hence it is desirable to have a means for monitoring the status of the CP system and the galvanic potential currently available.

In order to monitor the galvanic potential the CP system requires sensors located on suitable immersed portions of the vessel or structure. The sensors are wired to a central unit in order to supply power to the sensor so that potential measurements can be transmitted to the central unit and monitored. A problem with the wiring of such sensors is that it is not always possible or desirable to use external wiring along inaccessible or visible parts of the hull or to attach wiring onto moving parts of a vessel. An alternative to external wiring is to use through hull fittings, which in turn can cause problems with water leaking past the fitting. This is a particular problem for retrofitted sensors.

US2019360108 relates to a marine application where the anode is monitored for wear. When a predetermined level of wear is reached, then seawater leaking into the anode triggers a galvanic cell of a sensor and generates a signal. This solution does not provide continuous measurements of the CP system status or the galvanic potential as its sensor is only triggered when the anode has reached a predetermined level of wear and requires immediate replacement.

The object of the invention is to provide an improved marine cathodic protection monitoring system that solves the above problems.

### SUMMARY

In the subsequent text, the terms "on-board" and "outboard" are intended to describe components located within the hull of a vessel or on the outer surface thereof, respectively. Alternative terms such as "inner" and "outer" can also be used for this purpose. In the text, a "cathodically protected structure" is a metallic part or component that is protected from corrosion by a cathodic protection system. For a marine vessel, a protected structure can be the entire or parts of a propulsion unit, trim planes, propellers, etc.

According to one aspect, the disclosure relates to a marine cathodic protection monitoring system comprising an on-board internal monitoring unit arranged to receive measurement data from a submerged external unit. The external unit is mounted in direct contact with a cathodically protected structure and is powered by a dedicated source of power. Suitable dedicated sources of power will be described in further detail below.

The external unit comprises one or more reference electrodes arranged in electrical connection with the cathodically protected structure, a voltmeter arranged to monitor the potential difference between one of the reference electrodes and the cathodically protected structure and means for transferring data using a wireless protocol. The means used for transferring data to the monitoring unit can be a transponder for transmitting measurement data only. Alternatively, the means for transferring data is a transceiver arranged to transmit and receive signals to and from the monitoring unit.

The external unit is arranged to transmit measurement data indicating the current potential difference for the structure to the internal monitoring unit. The internal monitoring unit can thereby determine whether the potential difference is within a predetermined range or not.

As described above the external unit is a stand-alone unit powered by a dedicated source of power. According to a first example, the dedicated source of power is an internal source of power integrated in the external unit. The internal source of power is arranged to utilise an electromotive force created by an electrolytic reaction between the cathodically protected structure and one or more noble metal parts mounted to the external unit and where surrounding seawater is arranged to act as an electrolyte. In this example, the external unit comprises a metallic attachment part connected to the cathodically protected structure and to the one or more noble metal parts.

According to a second example, the dedicated source of power is a disposable or rechargeable battery enclosed in or arranged in a sealed cavity within the body of the external unit. According to a third example, the dedicated source of power is a solar cell arrangement located adjacent the external unit. According to a fourth example, the dedicated source of power is a motion power arrangement located adjacent the external unit and arranged to utilize the movement of the vessel. Depending on the source of power provided the means for transferring data can be provided with a converter for transforming the supplied power to a current and voltage suitable for the transponder or transceiver used. This is usually the case if the source of power is an electrochemical source of power as described above.

In response to the received measurement data from the external unit the internal monitoring unit is arranged to generate an audible and/or visual warning to an operator if it is determined that galvanic protection potential is outside the predetermined range.

The external unit is mounted in direct contact with a cathodically protected structure, wherein the one or more reference electrodes is in electrical connection with the cathodically protected structure directly or via a metallic attachment part of the external unit. The metallic attachment part is preferably an integral part of the external unit body.

According to a second aspect, the disclosure relates to an external unit used in a marine cathodic protection monitoring system as described above. The external unit comprises a body comprising an electrically insulating non-conductive material that is impermeable to seawater. A non-exclusive list of suitable materials for this purpose comprises polyethylene, polypropylene, phenolic plastics, nylon, acetal resin, e.t.c. The external unit further comprises a metallic attachment part for fixing the external unit in direct electrical contact with a cathodically protected structure and one or more reference electrodes mounted to the body separated from and in electrical connection with the attachment part. The reference electrodes are mounted exposed to the surrounding water and are electrically connected to the protected structure via the metallic attachment part. A voltmeter is arranged between the attachment part and one of the reference electrodes in order to measure the potential difference between the reference electrode and the protected structure via the metallic attachment part. The external unit further comprises a means for transferring data using a wireless protocol which means can be a transponder or a transceiver. A dedicated source of power is provided to supply power to the means for transferring measured data.

Measurements for the potential difference can be transmitted continuously, intermittently at regular intervals or upon request from the monitoring unit or the operator. The latter example will require a transceiver allowing the monitoring unit to send a query to the external unit. If continuous potential measurement is not desired, then a suitable interval for intermittent measurements can be set at 10-20 minutes or more as corrosion is a relatively slow process. Longer intervals will of course also entail saving power and extend the useful life of the dedicated power source. These measurement options, including interval settings, can be selected by the operator. Transferred data can also comprise the status of the dedicated power source in order to ensure that sufficient power is available to enable data transmission from the external unit.

As described above the external unit is a stand-alone unit powered by a dedicated source of power. According to a first example, the dedicated source of power is an internal source of power integrated in the external unit. The internal source of power is arranged to utilise an electromotive force created by an electrolytic reaction between a metallic attachment part connected to the cathodically protected structure and in electrical connection with one or more noble metal parts mounted to the external unit and where surrounding seawater is arranged to act as an electrolyte. According to a second example, the dedicated source of power is a disposable or rechargeable battery enclosed in or arranged in a sealed cavity within the body of the external unit. According to a third example, the dedicated source of power is a solar cell arrangement located adjacent the external unit. According to a fourth example, the dedicated source of power is a motion power arrangement located adjacent the external unit and arranged to utilize the movement of the vessel.

According to a third aspect, the disclosure relates to a marine structure or a marine vessel comprising a cathodic protection monitoring system having an external unit as described in any one of the above-mentioned examples.

The arrangement solves problems relating to the supply of power to submerged sensors used in cathodic protection systems for marine applications. This is a particular problem for retrofitted sensors, wherein the system allows physical wiring for the sensors to be eliminated. The provision of a stand-alone continuously powered sensor allows the operator to monitor corrosion protection status continuously and take action in good time before problems with the corrosion protection system occurs. Should the component become damaged by external action or malfunction for any reason, then the operator can be notified immediately. It is also possible to determine whether one or more components will need replacement, for instance, during a planned service of the vessel or if the replacement can wait until the vessel is taken out of the water for off-season storage. As the external unit comprises a dedicated power source it can be mounted at any suitable position within transmission range of its monitoring unit.

### BRIEF DESCRIPTION OF THE DRAWINGS

In the following text, the invention will be described in detail with reference to the attached drawings. These schematic drawings are used for illustration only and do not in any way limit the scope of the invention. In the drawings:
- Figure 1: shows a schematically illustrated vessel comprising a corrosion protection system according to a first example;
- Figure 2: shows a schematically illustrated vessel comprising a corrosion protection system according to a second example;
- Figure 3: shows a schematic cross-section through an external unit;
- Figure 4: shows a schematic plan view of an external unit according to a first example;
- Figure 5: shows a schematic plan view of an external unit according to a second example;
- Figure 6: shows a schematic plan view of an external unit according to a third example;
- Figure 7: shows a schematic perspective view of a first alternative external unit;
- Figure 8: shows a schematic perspective view of a second alternative external unit; and
- Figure 9: shows a schematic perspective view of a third alternative external unit.

### DETAILED DESCRIPTION OF EXAMPLE EMBODIMENTS OF THE INVENTION

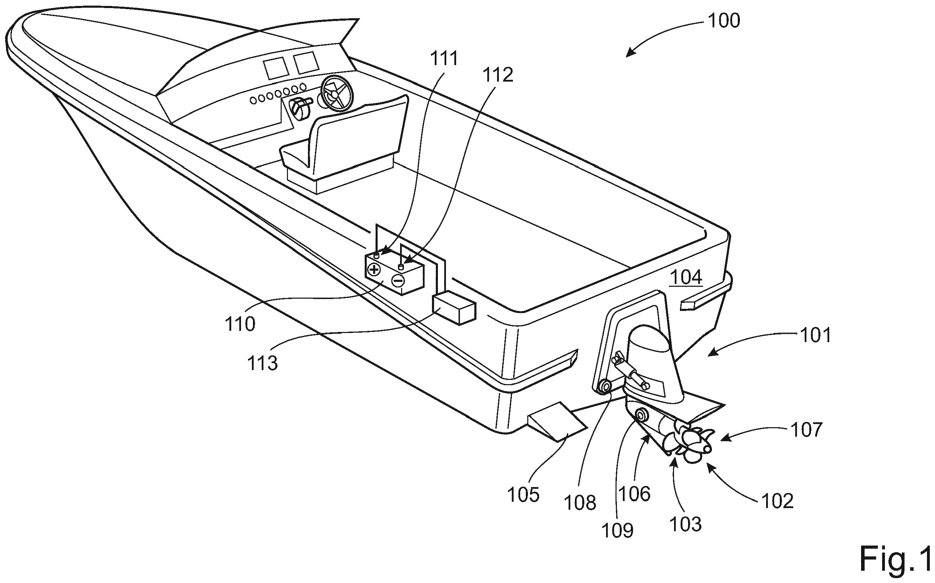

Figure 1 shows a schematically illustrated vessel comprising a corrosion protection system according to a first example. The vessel comprises a hull with a transom 104 to which a marine propulsion system is attached. The propulsion system in this example comprises a single driveline housing 101 at least partially submerged in water, a torque transmitting drive shaft 106 (not shown) extending out of the driveline housing 101, and a pair of counterrotating propellers 102, 103 mounted on the drive shaft 106. In the current example, both propellers 102, 103 are electrically isolated from its drive shaft 106. However, this is not a requirement for operation of the system. Metallic components such as the driveline housing 101, a metallic portion of the transom 104 and trim planes 105 (one shown) can be protected against corrosion using a passive cathodic protection arrangement. Note that this is a non-exclusive list of metallic components suitable for marine growth and corrosion protection. In this example, stand-alone external units 108, 109 are mounted on the metallic portion of the transom 104, driveline housing 101, respectively. An internal monitoring unit 113, hereinafter referred to as a control unit 113, is arranged to monitor the potential difference of the corrosion protection system. In order to achieve this, the positive terminal 111 and the negative terminal 112 of the battery 110 are connected to the control unit 113 In order to supply the control unit with power.

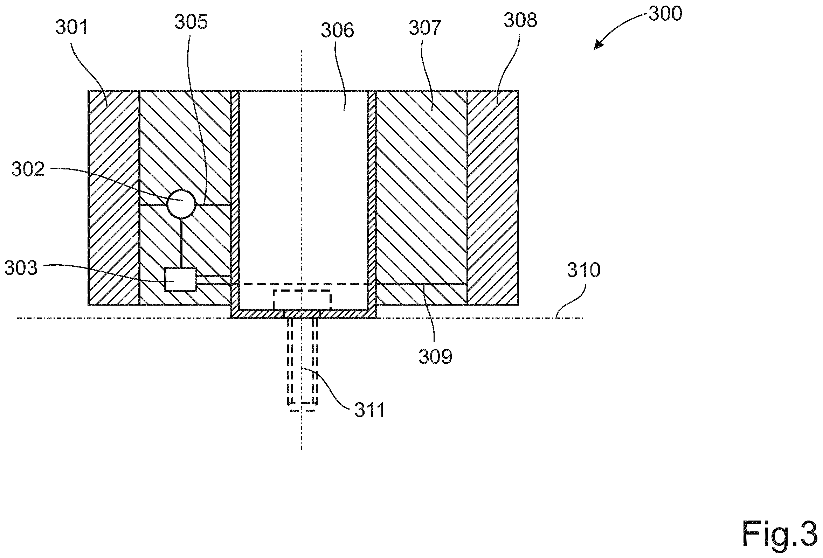

Each external unit 108, 109 is arranged to measure the potential difference of the system by means on an integral voltmeter (see Fig.3). Measured values of potential difference can be transmitted to the control unit 113 monitoring the protection potential. Measurements for the potential difference can be transmitted continuously, intermittently at regular intervals or upon request from the control unit 113. This timing can be selected by the operator. In response to the received measurement data from the external units 108, 109 the control unit 113 is arranged to generate an audible and/or visual warning to an operator if it is determined that galvanic protection potential is outside the predetermined range. Transferred data can also comprise the status of a dedicated power source in the external unit in order to ensure that sufficient power is available to enable data transmission from the external unit to the control unit.

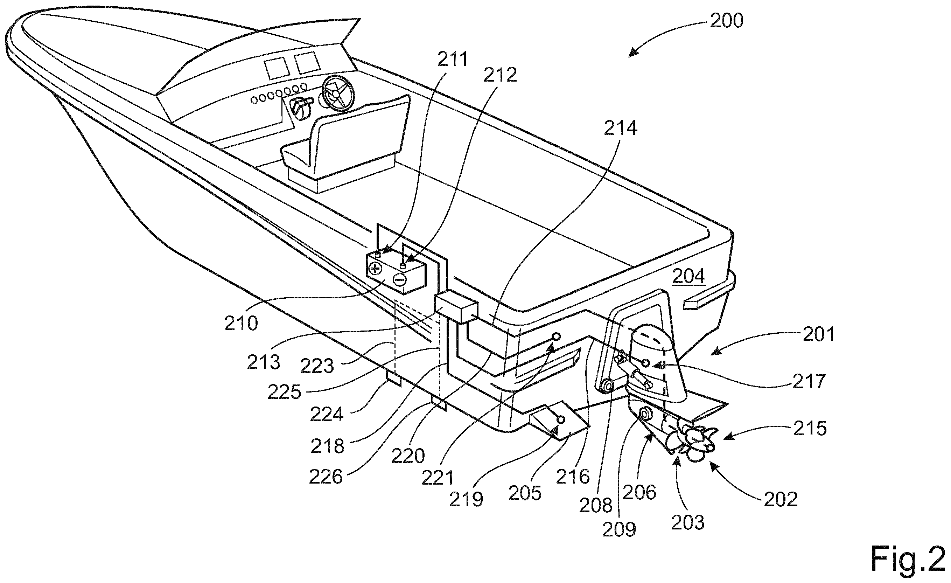

Figure 2 shows a schematically illustrated vessel 200 comprising a corrosion protection system according to a second example. This figure shows the corrosion protection system and its external unit employed as a back-up system for an impressed current corrosion protection (ICCP) system. The vessel 200 comprises a hull with a transom 204 to which a marine propulsion system is attached. The propulsion system in this example comprises a single driveline housing 201 at least partially submerged in water, a torque transmitting drive shaft 206 (not shown) extending out of the driveline housing 201, and a pair of counterrotating propellers 202, 203 mounted on the drive shaft 206. In the current example, both propellers 202, 203 are electrically isolated from its drive shaft 206. The drive shaft arrangement is shown in Figure 2 and will be described in further detail below. Each electrically isolated propeller 202, 203 to be protected against corrosion is connected to a negative terminal 212 of a direct current (DC) power source 210, such as a battery, in order to form a cathode. In the same way, each additional metallic component 201, 204, 205 to be protected against corrosion is connected to a negative terminal 212 of the direct current power source 210, in order to form cathodes. An ICCP control unit 213 comprising an internal monitoring unit is connected to the direct current power source 210 and distributes current to all component parts forming an electrical circuit. The ICCP control unit 213 is arranged to regulate the voltage and current output from the direct current power source 210. In order to assist regulation of the voltage and current output a reference electrode 224 is mounted on the hull and is connected to the ICCP control unit 213 via an electrical wire 223. The reference electrode is preferable mounted remote from the protected structure in order to avoid measurement errors due to local variations in the electrical field around the protected structure. The reference electrode 224 measures a voltage difference between itself and the metallic components, which is directly related to the amount of protection received by the anode. The ICCP control unit 213 compares the voltage difference between the reference electrode 224 and the protected structure. The current output to the protected structure is then automatically adjusted by the control unit to maintain the electrode voltage equal to a pre-set voltage.

Regulation of the voltage and current output from the direct current power source is controlled to automate the current output while the voltage output is varied, or to automate the voltage output while the current output is varied. This allows the corrosion protection level to be maintained under changing conditions, e.g. variations in water resistivity, water temperature or water velocity. In a sacrificial anode system, increases in the seawater resistivity can cause a decrease in the anode output and a decrease in the amount of protection provided, while a change from stagnant conditions results in an increase in current demand to maintain the required protection level. With ICCP systems protection does not decrease in the range of standard seawater nor does it change due to moderate variations in current demand. An advantage of ICCP systems is that they can provide constant monitoring of the electrical potential at the water/protected structure interface and can adjust the output to the anodes in relation to this. An ICCP system comprising a reference electrode is more effective and reliable than sacrificial anode systems where the level of protection is unknown and uncontrollable.

The corrosion protection system in this example is an impressed current cathodic protection (ICCP) arrangement using the propellers 202, 203 as a cathode 215. In this example, hull mounted anodes (not shown) connected to the positive terminal 211 are used. In Figure 2, the metallic component to be protected against corrosion is the driveline housing 201, the trim tabs 205 (one shown), and a metal portion of the hull, in this case the transom 204. Note that this is a non-exclusive list of metallic components suitable for corrosion protection. In order to achieve this, the positive terminal 211 and the negative terminal 212 of the battery 210 are connected to the ICCP control unit 213. The ICCP control unit 213 is arranged to connect the negative terminal 212 to the propellers 202, 203 via a first electrical wire 214. The ICCP control unit 213 is further arranged to connect the negative terminal 212 to an electrical connector 217 on the driveline housing 201 via a second electrical wire 216. The negative terminal 212 is also connected to an electrical connector 219 on the trim tab 205 via a third electrical wire 218 and is connected to an electrical connector 221 on the transom 204 via a fourth electrical wire 220. The corrosion protection system is further provided with a passive, sacrificial anode 226 that can provide protection if a failure occurs in the active antifouling arrangement. The sacrificial anode 226 can be located at any suitable location on the vessel and is connectable to the ICCP control unit 213 via a fifth electrical wire 225.

The corrosion protection system in this example can be provided with at least one external monitoring unit 208, 209 acting as back-up sacrificial anodes are arranged to communicate with the internal monitoring unit in the ICCP control unit 213. Each external unit 208, 209 is arranged to measure the potential difference of the system by means on an integral voltmeter (see Fig.3). Measured values of potential difference can be transmitted to the ICCP control unit 213 monitoring the protection potential. Measurements for the potential difference can be transmitted continuously, intermittently at regular intervals or upon request from the ICCP control unit 213. In response to the received measurement data from the external units 208, 209 the ICCP control unit 213 is arranged to generate an audible and/or visual warning to an operator if it is determined that galvanic protection potential is outside the predetermined range. Transferred data can also comprise the status of a dedicated power source in the external unit in order to ensure that sufficient power is available to enable data transmission from the external unit to the control unit.

Figure 3 shows a schematic cross-section through an external unit 300 attached to a protected structure and used in a marine cathodic protection monitoring system. The external unit 300 comprises a body 307 comprising an electrically insulating material, a metallic attachment part 306 for fixing the external unit in direct electrical contact with a cathodically protected structure 310 and a reference electrode 301 mounted to the body separated from and in electrical connection with the attachment part 306. A voltmeter 302 is arranged in an electrical connection 305 between the attachment part 306 and the reference electrode 301 in order to monitor the potential difference between the reference electrode 301 and the cathodically protected structure 310. The voltmeter 302 is connected to a means for transferring data 303 using a wireless protocol. The means for transferring data 303 can be a transponder or a transceiver arranged to communicate with an internal monitoring unit in an on-board control unit (see Fig.1, "113"). The means for transferring data 303 is powered by a dedicated source of power 308 arranged in the body 307.

The example in Figure 3 shows a dedicated source of power 308 comprising at least one noble metal part 308 (one shown) mounted to the body 307 separated from and in electrical connection with the attachment part 306 via the means for transmitting data 303. An electromotive force is created by an electrolytic reaction between the metallic attachment part 306 connected to the cathodically protected structure 310 and in electrical connection with the noble metal part 308 mounted to the body 307 of the external unit 300 and where surrounding seawater is arranged to act as an electrolyte. The electrochemical energy supplied by this source of power can require the means for transferring data 303 to be provided with a converter for transforming the supplied power to a current and voltage suitable for the transponder or transceiver used.

The external unit 300 is arranged to be fixed to and be in electrical connection with the protected structure 310 via the attachment part 306. As schematically indicated in Figure 3, a suitable fastener such as a threaded screw 311 can be passed through an opening in the attachment part 306 and fixed into a corresponding threaded a hole in the protected structure 310.

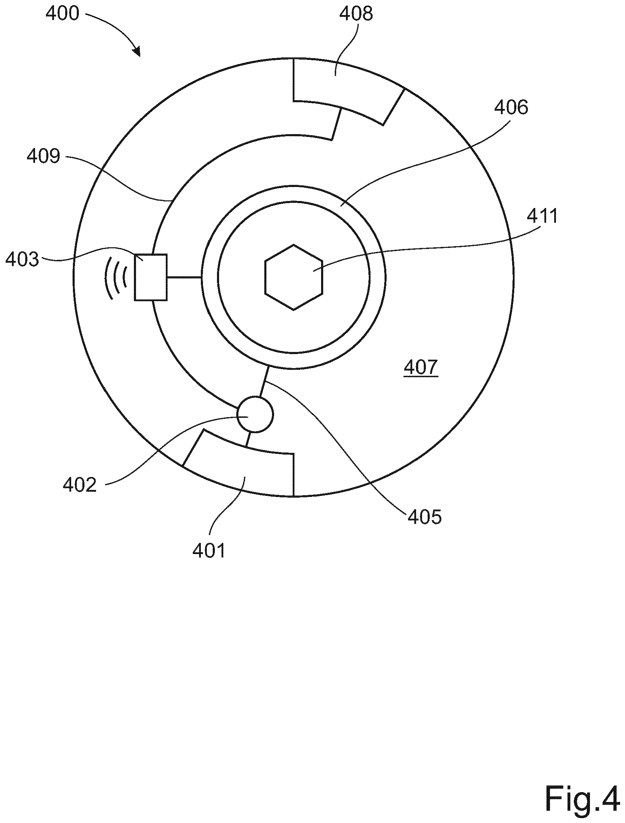

Figure 4 shows a schematic plan view of an external unit 400 according to a first example. The external unit 400 comprises a body 407 comprising an electrically insulating material, a metallic attachment part 406 for fixing the external unit in direct electrical contact with a cathodically protected structure (see Fig.3; "310") and a reference electrode 401 mounted to the body separated from and in electrical connection with the attachment part 406. A voltmeter 402 is arranged in an electrical connection 405 between the attachment part 406 and the reference electrode 401 in order to monitor the potential difference between the reference electrode 401 and the cathodically protected structure. The voltmeter 402 is connected to a means for transferring data 403 using a wireless protocol. The means for transferring data 403 can be a transponder or a transceiver arranged to communicate with an internal monitoring unit in an on-board control unit (see Fig.1, "113"). The means for transferring data 403 is powered by a dedicated source of power 408 arranged in the body 407.

The example in Figure 4 shows a dedicated source of power 408 comprising at a noble metal part 408 mounted to the body 407 separated from and in electrical connection with the attachment part 406 via the means for transmitting data 403. An electromotive force is created by an electrolytic reaction between the metallic attachment part 406 connected to the cathodically protected structure and in electrical connection with the noble metal part 408 mounted to the body 407 of the external unit 400 and where surrounding seawater is arranged to act as an electrolyte.

The external unit 400 is arranged to be fixed to and be in electrical connection with the protected structure via the attachment part 406. As schematically indicated in Figure 4, a suitable fastener such as a threaded screw 411 can be passed through an opening in the attachment part 406 and fixed into a corresponding threaded a hole in the protected structure (not shown).

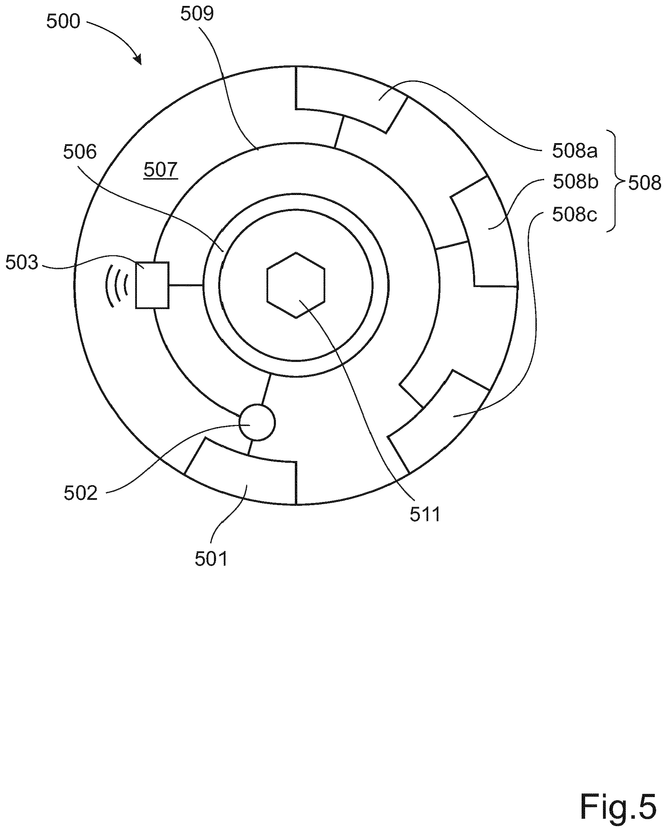

Figure 5 shows a schematic plan view of an external unit 500 according to a second example. The external unit 500 comprises a body 507 comprising an electrically insulating material, a metallic attachment part 506 for fixing the external unit in direct electrical contact with a cathodically protected structure (see Fig.3; "310") and a reference electrode 501 mounted to the body separated from and in electrical connection with the attachment part 506. A voltmeter 502 is arranged in an electrical connection 505 between the attachment part 506 and the reference electrode 501 in order to monitor the potential difference between the reference electrode 501 and the cathodically protected structure. The voltmeter 502 is connected to a means for transferring data 503 using a wireless protocol. The means for transferring data 503 can be a transponder or a transceiver arranged to communicate with an internal monitoring unit in an on-board control unit (see Fig.1, "113"). The means for transferring data 503 is powered by a dedicated source of power 508 arranged in the body 507.

The example in Figure 5 shows a dedicated source of power 508 comprising three noble metal parts 508a, 508b, 508c mounted to the body 507 separated from and in electrical connection with the attachment part 506 via the means for transmitting data 503. An electromotive force is created by an electrolytic reaction between the metallic attachment part 506 connected to the cathodically protected structure and in electrical connection with the noble metal parts 508a, 508b, 508c mounted to the body 507 of the external unit 500 and where surrounding seawater is arranged to act as an electrolyte.

The external unit 500 is arranged to be fixed to and be in electrical connection with the protected structure via the attachment part 506. As schematically indicated in Figure 5, a suitable fastener such as a threaded screw 511 can be passed through an opening in the attachment part 506 and fixed into a corresponding threaded a hole in the protected structure (not shown).

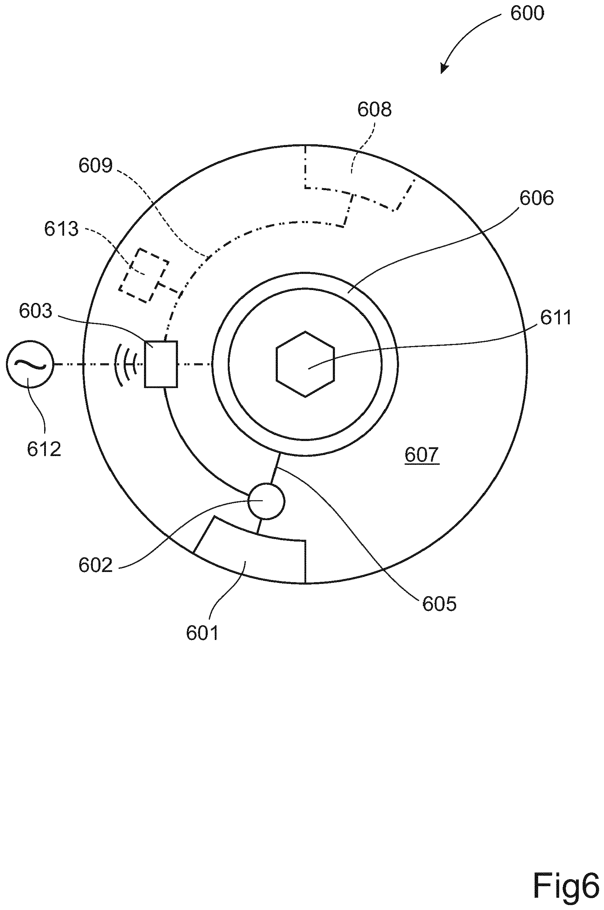

Figure 6 shows a schematic plan view of an external unit 600 according to a third example. The external unit 600 comprises a body 607 comprising an electrically insulating material, a metallic attachment part 606 for fixing the external unit in direct electrical contact with a cathodically protected structure (see Fig.3; "310") and a reference electrode 601 mounted to the body separated from and in electrical connection with the attachment part 606. A voltmeter 602 is arranged in an electrical connection 605 between the attachment part 606 and the reference electrode 601 in order to monitor the potential difference between the reference electrode 601 and the cathodically protected structure. The voltmeter 602 is connected to a means for transferring data 603 using a wireless protocol. The means for transferring data 603 can be a transponder or a transceiver arranged to communicate with an internal monitoring unit in an on-board control unit (see Fig.1, "113"). The means for transferring data 603 is powered by a dedicated source of power 612 arranged adjacent the body 607. The source of power 612 can be a solar cell arrangement or a motion power arrangement. The example in Figure 6 also shows a first optional dedicated source of power 608 comprising a noble metal part 608 mounted to the body 607 separated from and in electrical connection with the attachment part 606 via the means for transmitting data 603. An electromotive force is created by an electrolytic reaction between the metallic attachment part 606 connected to the cathodically protected structure and in electrical connection with the noble metal parts 608 mounted to the body 607 of the external unit 600 and where surrounding seawater is arranged to act as an electrolyte. Figure 6 further shows a second optional dedicated source of power 613 comprising an internal disposable or rechargeable battery wherein the positive and negative terminals of the battery (only one wire shown) are connected to the means for transferring data 603.

The external unit 600 is arranged to be fixed to and be in electrical connection with the protected structure via the attachment part 606. As schematically indicated in Figure 6, a suitable fastener such as a threaded screw 611 can be passed through an opening in the attachment part 606 and fixed into a corresponding threaded a hole in the protected structure (not shown).

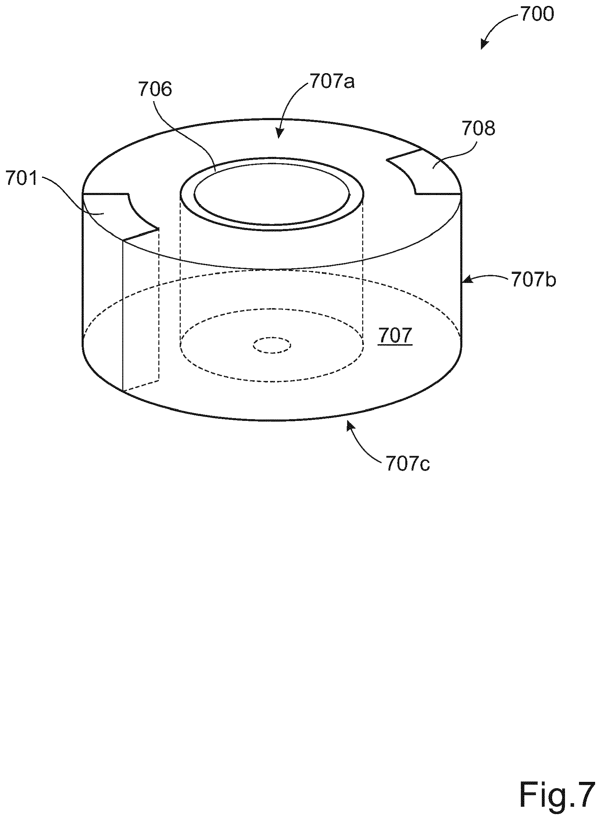

Figure 7 shows a schematic perspective view of a first alternative external unit 700. The external unit 700 comprises a body 707 comprising an electrically insulating material, a metallic attachment part 706 for fixing the external unit in direct electrical contact with a cathodically protected structure (not shown) and a reference electrode 701 mounted to the body separated from and in electrical connection with the attachment part 706. The body 707 comprises an upper annular surface 707a, a lower annular surface 707c and a cylindrical side surface 707b connecting the upper and lower surfaces 707a, 707c.

The example in Figure 7 shows a dedicated source of power 708 comprising a noble metal part 708 mounted to the body 707 separated from and in electrical connection with the attachment part 706 via the means for transmitting data 703. An electromotive force is created by an electrolytic reaction between the metallic attachment part 706 connected to the cathodically protected structure and in electrical connection with the noble metal part 708 mounted to the body 707 of the external unit 700 and where surrounding seawater is arranged to act as an electrolyte.

Figure 7 shows the reference electrode 701 and the noble metal part 708 moulded into the body 707 and extending from the upper surface 707a to the lower surface 707c. Both the reference electrode 701 and the noble metal part 708 have exposed surfaces at both ends and along their outer surfaces which interrupt the cylindrical side surface 707b. When immersed, the reference electrode 701 and the noble metal part 708 will be exposed to seawater on three sides. When mounted the lower ends of the reference electrode 701 and the noble metal part 708 must be kept out of contact with the protected surface.

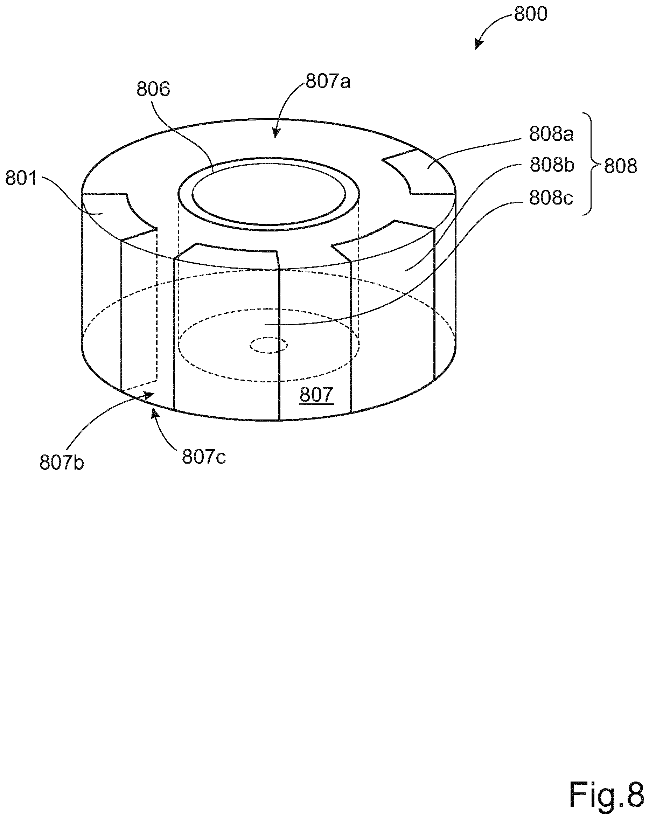

Figure 8 shows a schematic perspective view of a second alternative external unit 800. The external unit 800 comprises a body 807 comprising an electrically insulating material, a metallic attachment part 806 for fixing the external unit in direct electrical contact with a cathodically protected structure (not shown) and a reference electrode 801 mounted to the body separated from and in electrical connection with the attachment part 806. The body 807 comprises an upper annular surface 807a, a lower annular surface 807c and a cylindrical side surface 807b connecting the upper and lower surfaces 807a, 807c.

The example in Figure 8 shows a dedicated source of power 808 comprising a noble metal parts 808a, 808b, 808c mounted to the body 807 separated from and in electrical connection with the attachment part 806 via the means for transmitting data 803. An electromotive force is created by an electrolytic reaction between the metallic attachment part 806 connected to the cathodically protected structure and in electrical connection with the noble metal parts 808a, 808b, 808c mounted to the body 807 of the external unit 800 and where surrounding seawater is arranged to act as an electrolyte.

Figure 8 shows the reference electrode 801 and the noble metal parts 808a, 808b, 808c moulded into the body 807 and extending from the upper surface 807a to the lower surface 807c. Both the reference electrode 801 and the noble metal parts 808a, 808b, 808c have exposed surfaces at both ends and along their outer surfaces which interrupt the cylindrical side surface 807b. When immersed, the reference electrode 801 and the noble metal part 808 will be exposed to seawater on three sides. When mounted the lower ends of the reference electrode 801 and the noble metal parts 808a, 808b, 808c must be kept out of contact with the protected surface.

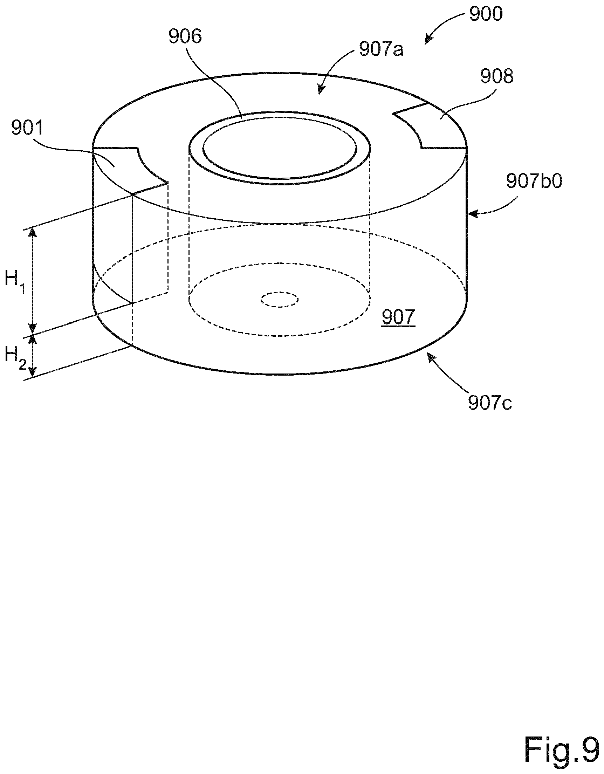

Figure 9 shows a schematic perspective view of a third alternative external unit 900. The external unit 900 comprises a body 907 comprising an electrically insulating material, a metallic attachment part 906 for fixing the external unit in direct electrical contact with a cathodically protected structure (not shown) and a reference electrode 901 mounted to the body separated from and in electrical connection with the attachment part 906. The body 907 comprises an upper annular surface 907a, a lower annular surface 907c and a cylindrical side surface 907b connecting the upper and lower surfaces 907a, 907c.

The example in Figure 9 shows a dedicated source of power 908 comprising a noble metal part mounted to the body 907 separated from and in electrical connection with the attachment part 906 via the means for transmitting data 903. An electromotive force is created by an electrolytic reaction between the metallic attachment part 906 connected to the cathodically protected structure and in electrical connection with the noble metal part 908 mounted to the body 907 of the external unit 900 and where surrounding seawater is arranged to act as an electrolyte.

Figure 9 shows the reference electrode 901 and the noble metal part 908 moulded into the body 907 and extending from the upper surface 907a a distance H₁ part of the way towards the lower surface 907c. The reference electrode 901 and the noble metal part 908 terminate a distance H₂ from the lower surface 907c. Consequently, both the reference electrode 901 and the noble metal parts 908a, 908b, 908c have exposed surfaces at one end and along their outer surfaces which interrupt the cylindrical side surface 907b. When immersed, the reference electrode 901 and the noble metal part 908 will be exposed to seawater on two sides. When mounted the lower ends of the reference electrode 901 and the noble metal parts 908a, 908b, 908c is inherently kept out of contact with the protected surface.

The present disclosure should not be deemed to be limited to the embodiments described above, but rather a number of further variants and modifications are conceivable within the scope of the following patent claims.

## Claims

1. A marine cathodic protection monitoring system comprising an on-board internal monitoring unit (113; 213) arranged to receive measurement data from a submerged external unit (108, 109; 208, 209; 300; 500; 600; 700; 800; 900), which external unit is mounted in direct contact with a cathodically protected structure (310) and which external unit is powered by a dedicated source of power (308; 508; 608; 612; 613),
wherein the external unit comprises:
- one or more reference electrodes (301; 501; 601; 701; 801; 901) arranged in electrical connection with the cathodically protected structure (310);
- a voltmeter (302; 502; 602) arranged to monitor the potential difference between one of the reference electrodes and the cathodically protected structure (310);
- means for transferring data (303; 503; 603) using a wireless protocol, and
wherein the external unit (108, 109; 208, 209; 300; 500; 600; 700; 800; 900) is arranged to transmit measurement data indicating the current potential difference of the structure to the internal monitoring unit (113; 213) and wherein the internal monitoring unit is arranged to determine whether the potential difference is within a predetermined range.

2. A marine cathodic protection monitoring system according to claim 1, wherein the dedicated source of power (308; 508; 608; 613; 708; 808; 908) is an internal source of power integrated in the external unit.

3. A marine cathodic protection monitoring system according to claim 2, wherein the dedicated source of power (308; 508; 608; 708; 808; 908) is arranged to utilise an electromotive force created by an electrolytic reaction between a metallic attachment part connected to the cathodically protected structure and in electrical connection with one or more noble metal parts mounted to the external unit and where surrounding seawater is arranged to act as an electrolyte.

4. A marine cathodic protection monitoring system according to claim 2, wherein the dedicated source of power (613) is a disposable or rechargeable battery.

5. A marine cathodic protection monitoring system according to claim 1, wherein the dedicated source of power (612) is a solar cell arrangement.

6. A marine cathodic protection monitoring system according to claim 1, wherein the dedicated source of power (612) is a motion power arrangement utilizing wave power or vessel movement.

7. A marine cathodic protection monitoring system according to any one of the above claims, wherein the means for transferring data comprises a transceiver.

8. A marine cathodic protection monitoring system according to any one of the above claims, wherein the internal monitoring unit (113; 213) is arranged to generate a warning to an operator if it is determined that galvanic protection potential is outside the predetermined range.

9. A marine cathodic protection monitoring system according to any one of the above claims, wherein the one or more reference electrodes (301; 501; 601; 701; 801; 901) is in electrical connection with the cathodically protected structure via a metallic attachment part (306; 506; 606; 706; 806; 906) of the external unit.

10. An external unit used in a marine cathodic protection monitoring system according to claim 1, wherein the external unit (300; 500; 600; 700; 800; 900) comprises
- a body (307; 507; 607; 707; 807; 907) comprising an electrically insulating material;
- a metallic attachment part (306; 506; 606; 706; 806; 906) for fixing the external unit in direct electrical contact with a cathodically protected structure;
- one or more reference electrodes (301; 501; 601; 701; 801; 901) mounted to the body separated from and in electrical connection with the attachment part;
- a voltmeter (303; 503; 603) arranged between the attachment part and one of the reference electrodes;
- means for transferring data (303; 503; 603) using a wireless protocol; and
- a dedicated source of power (308; 508; 608; 621; 613; 708; 808; 908).

11. An external unit used in a marine cathodic protection monitoring system according to claim 10, wherein the voltmeter (303; 503; 603) is arranged to measure a potential difference between one of the-reference electrodes (301; 501; 601; 701; 801; 901) and the protected structure via the attachment part (306; 506; 606; 706; 806; 906).

12. An external unit used in a marine cathodic protection monitoring system according to claim 10 or 11, wherein the means for transferring data comprises a transceiver.

13. An external unit used in a marine cathodic protection monitoring system according to any one of claims 10-12, wherein the external unit comprises one or more noble metal parts (308; 508; 608; 708; 808; 908) mounted to the body separated from and in electrical connection with the attachment part via the means for transmitting data (303; 503; 603).

14. An external unit used in a marine cathodic protection monitoring system according to any one of claims 10-13, wherein the dedicated source of power (613) is a disposable or rechargeable battery.

15. Marine structure or vessel (100; 200) comprising a marine cathodic protection monitoring system according to claim 1.
